# FASCICULE DE BREVET EUROPEEN

(11) **EP 3 748 370 B1**
(45) Date de publication et mention de la délivrance du brevet: **16.08.2023**
(21) Numéro de dépôt: 20178435.2
(22) Date de dépôt: 05.06.2020
(51) Int. Cl.: G01R 15/18, H01F 5/00

(54) **CAPTEURS DE COURANT ET SYSTÈMES DE MESURE ASSOCIÉS**
STROMSENSOREN UND ENTSPRECHENDE MESSSYSTEME
CURRENT SENSORS AND ASSOCIATED MEASURING SYSTEMS

(30) Priorité: 07.06.2019 FR 1906093
(43) Date de publication de la demande: 09.12.2020
(73) Titulaire: Schneider Electric Industries SAS, 92500 Rueil Malmaison (FR)
(72) Inventeur: RONDOT, Loïc, 38050 Grenoble Cedex 09 (FR); URANKAR, Lionel, 38050 Grenoble Cedex 09 (FR)
(74) Mandataire: Lavoix

(56) Documents cités:
- FR-A1- 3 033 647
- US-A1- 2008 079 418
- US-A1- 2009 058 398
- US-A1- 2019 154 733

## Description

La présente invention concerne des capteurs de courant et des systèmes de mesure associés.

Les enroulements de Rogowski sont des capteurs de courant capables de mesurer l'intensité d'un courant alternatif circulant dans un conducteur électrique.

Un tel capteur comporte généralement une bobine enroulée autour d'une ligne de contour refermée autour d'une ouverture centrale dans laquelle est reçue le conducteur électrique. Le courant circulant dans le conducteur électrique induit une tension électrique aux bornes de la bobine.

Les enroulements de Rogowski peuvent être fabriqués sur un support de circuit imprimé (PCB). Par exemple, un substrat isolant est percé d'une pluralité de trous traversants agencés sur les faces du substrat avec un motif prédéfini le long d'un contour fermé de forme carrée autour d'une ouverture centrale. La bobine est formée en faisant passer un conducteur électrique au travers des trous traversants pour former des spires centrées sur la ligne de contour.

Les enroulements de Rogowski sur circuit imprimé (*PCB Rogowski coils* en anglais) ont notamment pour avantages d'être relativement simples et peu coûteux à fabriquer à l'échelle industrielle. Ils sont aussi faciles à miniaturiser. Les exemples d'art antérieur connus peuvent être vus dans les documents US 2009/058398 A1, FR 3 033 647 A1, US 2008/079418 A1 et US 2019/154733 A1.

Un inconvénient de tels capteurs de Rogowski sur circuit imprimé est que leur gain est faible et peut être insuffisant pour être utilisés dans certaines applications, notamment dans les applications liées à la protection d'installations de distribution d'électricité, par exemple lorsque ces capteurs sont utilisés comme capteurs de courant dans des déclencheurs de disjoncteurs. D'autre part, de tels capteurs peuvent être sujets à des problèmes de diaphonie, ce qui peut compliquer la détection d'un défaut électrique tel qu'un courant de court-circuit.

Il existe donc un besoin pour des capteurs de courant, notamment des enroulements de Rogowski sur circuit imprimé, qui remédient à ces inconvénients.

Selon un premier aspect de l'invention, un capteur de courant comporte :
- un substrat isolant pourvu d'une ouverture centrale ;
- un enroulement de Rogowski entourant l'ouverture centrale et incluant une première bobine et une deuxième bobine superposées et connectées électriquement en série, la première bobine et la deuxième bobine étant enroulées autour du substrat selon, respectivement, une première ligne de contour et une deuxième ligne de contour, chaque ligne de contour délimitant, dans le plan du substrat, un contour en forme de quadrilatère centré autour de l'ouverture centrale ;
dans lequel le contour en forme de quadrilatère délimité par la première ligne de contour a une longueur supérieure à la longueur du quadrilatère délimité par la deuxième ligne de contour et une largeur inférieure à la largeur du quadrilatère délimité par la deuxième ligne de contour.

Selon des aspects avantageux mais non obligatoires, un tel capteur de courant peut incorporer une ou plusieurs des caractéristiques suivantes, prises isolément ou suivant toute combinaison techniquement admissible :
- Chacune des bobines est partagée en une pluralité de segments de bobines agencés autour de l'ouverture centrale en étant superposés et sensiblement alignés le long des lignes de contour, chacun desdits segments comportant une pluralité de spires au moins en partie reçues dans des orifices traversants percés dans le substrat, les orifices traversant étant alignés le long de rangées.
- Pour chaque partie de bobine, les orifices associés aux première et deuxième bobines sont disposés en quinconce.
- Chaque spire comporte, dans les faces supérieure et inférieure de la bobine, une portion rectiligne orientée diagonalement, les portions rectilignes des bobines étant, dans chaque segment de bobine, alignées le long d'une bande de recouvrement s'étendant parallèlement auxdites rangées.
- Le capteur de courant comporte une zone de raccordement formée dans l'un des segments de bobine, ladite zone de raccordement comportant des orifices traversants disposés selon un motif prédéfini, le capteur de courant comportant en outre des orifices traversants supplémentaires disposés suivant le même motif et disposés dans un autre des segments de bobine symétriquement par rapport à la zone de raccordement
- Les orifices traversants sont des vias traversants s'étendant dans toute la profondeur d'une couche centrale du substrat.
- Lesdites bobines comportent également des zones d'angle disposées chacune dans l'angle entre deux segments de bobine adjacents et dans lesquels passent les conducteurs électriques desdites bobines pour raccorder les segments de bobine.
- Des plots métalliques de soudure sont disposés sur le substrat sur des emplacements alignés avec des spires d'une des bobines de l'enroulement.
- Une structure de blindage est formée sur au moins une partie du substrat pour protéger le capteur contre des perturbations électromagnétiques, cette structure comportant une piste électriquement conductrice raccordée à une masse électrique.

Selon un autre aspect de l'invention, un système de mesure comporte un capteur de courant tel que décrit précédemment et un circuit électronique de traitement configuré pour traiter le signal mesuré par le capteur de courant.

L'invention sera mieux comprise et d'autres avantages de celle-ci apparaîtront plus clairement à la lumière de la description qui va suivre d'un mode de réalisation d'un capteur de courant donnée uniquement à titre d'exemple et faite en référence aux dessins annexés, dans lesquels :
[Fig 1] la figure 1 est une représentation schématique d'un système de mesure comportant un capteur de courant conforme à des modes de réalisation de l'invention ;
[Fig 2] la figure 2 est une représentation schématique, selon une vue en élévation, d'un capteur de courant conforme à un premier mode de réalisation de l'invention ;
[Fig 3] la figure 3 est une représentation schématique, selon une vue en élévation, d'un capteur de courant selon une variante du premier mode de réalisation de l'invention ;
[Fig 4] la figure 4 est une représentation schématique simplifiée illustrant la superposition de bobines du capteur de courant de la figure 2 ;
[Fig 5] la figure 5 est une représentation schématique d'un capteur de courant conforme à un deuxième mode de réalisation de l'invention ;
[Fig 6] la figure 6 est une représentation schématique d'un capteur de courant conforme à un troisième mode de réalisation de l'invention ;
[Fig 7] la figure 7 est une représentation schématique d'un capteur de courant conforme à un quatrième mode de réalisation de l'invention ;
[Fig 8] la figure 8 est une représentation schématique d'un capteur de courant conforme à un cinquième mode de réalisation de l'invention ;

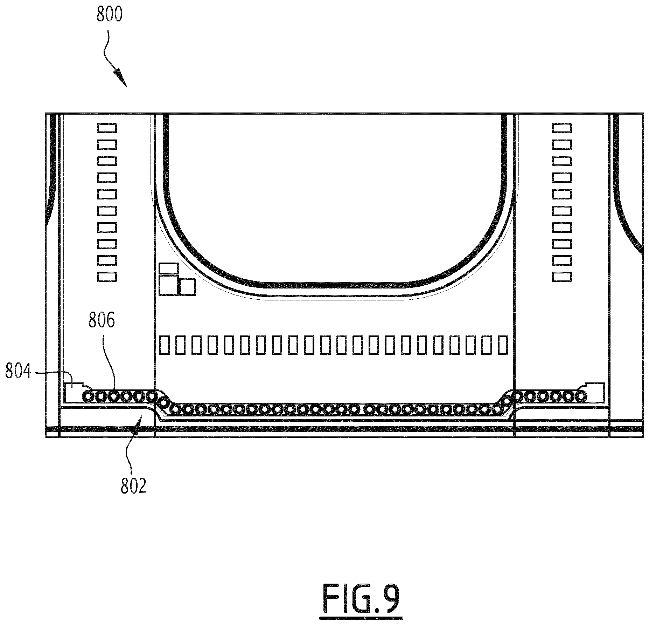

[Fig 9] la figure 9 est une représentation schématique d'un capteur de courant conforme à un sixième mode de réalisation de l'invention.

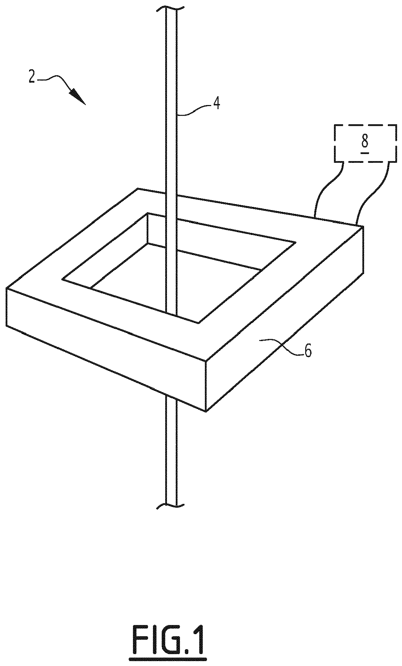

Sur la figure 1 est représenté un système de mesure 2 pour mesurer l'intensité d'un courant électrique circulant dans un conducteur électrique 4, tel qu'un câble ou un fil ou une barre de raccordement.

Le système 2 comporte ici un capteur de courant 6 et un circuit électronique de traitement 8 connecté au capteur de courant 6 et configuré pour traiter le signal mesuré par le capteur de courant 6.

Selon des modes de réalisation, le capteur de courant 6 comporte un enroulement de Rogowski formé sur un substrat et comportant deux bobines connectées électriquement en série, ces bobines étant superposées et enroulées sur le substrat.

Des bornes d'extrémité de l'enroulement sont raccordées à une entrée du circuit de traitement 8.

Selon des exemples, le courant circulant dans le conducteur électrique induit une tension électrique aux bornes de l'enroulement. Cette tension est proportionnelle à la dérivée temporelle de l'intensité du courant qui circule dans le conducteur 4. Le circuit de traitement 8 est, par exemple, configuré pour calculer la valeur du courant à partir du signal en tension fourni en sortie du capteur de courant 6.

Selon des modes de réalisation, le capteur de courant 6 et le circuit de traitement 8 peuvent être montés sur un même support de circuit imprimé.

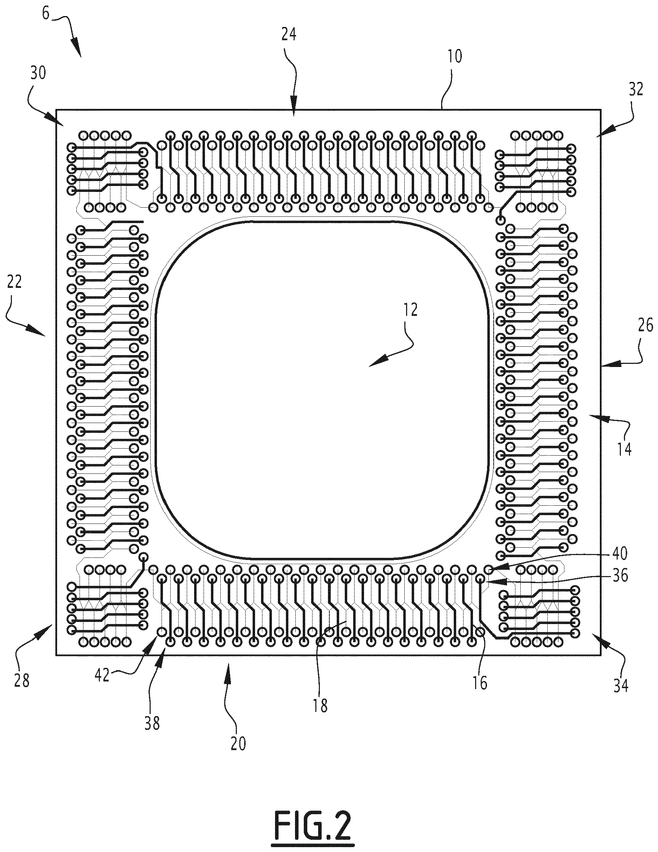

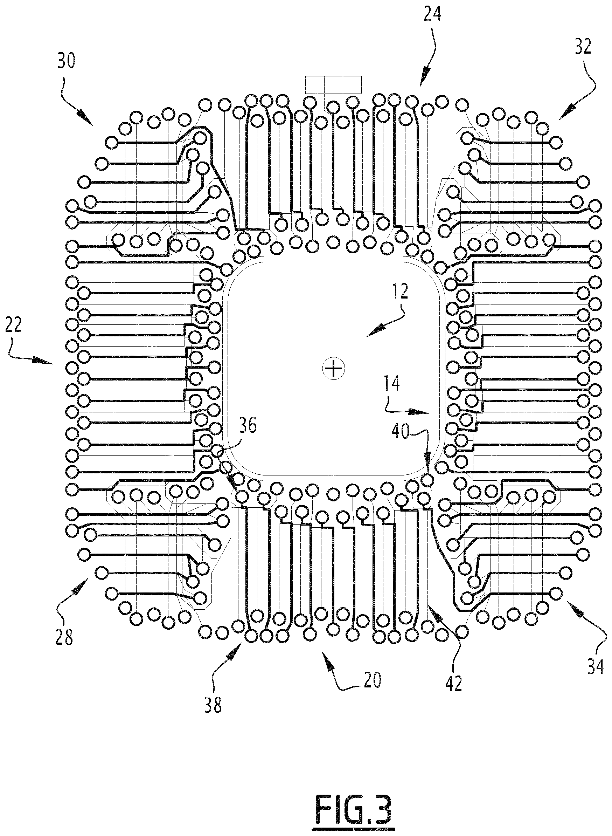

Un premier mode de réalisation du capteur de courant 6 est représenté sur les figures 2 et 3.

Le capteur de courant 6 comporte un substrat 10 électriquement isolant et ayant préférentiellement une forme plane.

Selon des exemples, le substrat 10 est un support de circuit imprimé comportant une couche ou plusieurs couches empilées d'un matériau polymère durci, tel qu'une résine époxy de type « FR-4 ».

Le substrat 10 peut, par exemple, être fabriqué par laminage, ou par dépôt de matière, ou par fabrication additive, ou par tout autre procédé approprié.

Les bobines sont, par exemple, formées par enroulement de fils électriquement conducteurs ou par dépôt de couches métalliques lors de la fabrication du substrat 10.

Comme illustré sur les figures 2 et 3, le capteur de courant 6 comporte un enroulement de Rogowski 14 entourant une ouverture 12 formée sur le substrat 10.

L'ouverture 12 est de préférence placée en position centrale du substrat 10.

Par exemple, l'ouverture 12 a une forme de polygone, tel qu'un quadrilatère. En variante, d'autres formes peuvent être envisagées, tel qu'un cercle ou une ellipse.

L'enroulement 14 inclut une première bobine 16 et une deuxième bobine 18 superposées et connectées électriquement en série. La première bobine 16 et la deuxième bobine 18 sont enroulées autour du substrat selon, respectivement, une première ligne de contour C1 et une deuxième ligne de contour C2.

Chaque ligne de contour C1 et C2 délimite, dans le plan du substrat 10, un contour en forme de quadrilatère centré autour de l'ouverture centrale. Par exemple, le quadrilatère est un rectangle.

Comme visible sur la figure 2, les bobines 16 et 18 de l'enroulement 14 sont superposées et sont entrelacés l'une avec l'autre. Par exemple, par « entrelacées », on entend que, sur au moins une partie de la longueur du contour fermé, les spires respectives des bobines 16 et 18 sont disposées en alternance.

De préférence, lesdites bobines 16 et 18 sont décalées l'une par rapport à l'autre selon une direction perpendiculaire au plan du substrat 10.

Par exemple, chaque bobine 16, 18 comporte une face supérieure et une face inférieure qui s'étendent dans des plans géométriques parallèles au plan du substrat 10. Les conducteurs électriques formant les bobines 16 et 18 s'étendent ensuite entre les faces supérieure et inférieure en traversant au moins une partie de l'épaisseur du substrat 10 au moyen de trous traversants orientés selon des directions perpendiculaires au plan du substrat 10, tels que des vias percés dans le substrat 10.

Par exemple, la face supérieure de la bobine 18 est disposée sur la face supérieure du substrat 10. La face inférieure de la bobine 18 est disposée dans une première couche interne dans le substrat 10. La face supérieure de la bobine 16 est disposée dans une deuxième couche interne dans le substrat 10 et sa face inférieure est disposée sur la face inférieure du substrat 10, la deuxième couche interne étant ici située entre la face supérieure du substrat 10 et la première couche interne.

Dans l'exemple illustré, la figure 2 représente une vue de la face supérieure du substrat 10. Les conducteurs électriques de la bobine 18 sont représentés en traits fins, et seuls les conducteurs électriques de la bobine 16 qui sont situés au niveau de la couche interne sont représentés en traits pleins, ceux disposés sur la face inférieure du substrat 10 n'étant pas dessinés pour faciliter la lecture de la figure.

Selon des exemples, chacune des bobines 16 et 18 est partagée en une pluralité de parties de bobines de forme rectiligne disposées autour de l'ouverture 12. Ces parties de bobine, aussi nommés segments de bobine dans ce qui suit, sont agencés de manière à délimiter un quadrilatère autour de l'ouverture 12 et sont sensiblement alignés le long des lignes de contour C1 et C2.

En variante, les segments de bobines ne sont pas nécessairement rectilignes et peuvent présenter une forme arrondie ou en arc de cercle.

Dans l'exemple illustré, quatre segments de bobine 20, 22, 24 et 26 sont disposées bout à bout à angle droit autour de l'ouverture 12, parallèlement au plan du substrat 10, de manière à former un carré ou un rectangle autour de l'ouverture 12. Les segments 20 et 24 sont parallèles et se font face de part et d'autre de l'ouverture 12. Les segments 22 et 26 sont disposés face à face de part et d'autre de l'ouverture 12 et sont orientés perpendiculairement aux segments 20 et 24.

Les bobines 16 et 18 comportent également des zones d'angle 28, 30, 32 et 34 disposées chacune dans l'angle entre deux segments de bobine adjacentes. Les conducteurs électriques des bobines 16 et 18 passent dans ces zones d'angle pour raccorder les segments de bobine deux à deux. Dans l'exemple illustré, la zone d'angle 28 est adjacente aux segments de bobines 20 et 22 ; la zone d'angle 30 est adjacente aux segments de bobines 22 et 24, et ainsi de suite.

De préférence, dans chacun desdits segments 20, 22, 24, 26, chaque bobine 16, 18 est enroulée selon une pluralité de spires qui sont au moins en partie formées par des orifices traversants percés dans le substrat, les orifices traversants étant alignés le long de rangées 36, 38, 40, 42.

Pour chaque segment de bobine 20, 22, 24 et 26, dans la deuxième couche interne, les conducteurs de la bobine 16 s'étendent entre une première rangée 36 d'orifices traversants et une deuxième rangée 38 d'orifices traversants. Dans les parties de bobine 20 et 24, la première rangée 36 est plus proche de l'ouverture 12 que la deuxième rangée 38, tandis que, pour les parties de bobine 22 et 24, la deuxième rangée 38 est plus proche de l'ouverture 12 que la première rangée 26.

De façon analogue, pour chaque segment de bobine 20, 22, 24 et 26, dans la face supérieure du substrat 10, les conducteurs de la bobine 18 s'étendent entre une troisième rangée 40 d'orifices traversants et une quatrième rangée 42 d'orifices traversants. Dans les segments de bobine 20 et 24, la troisième rangée 40 est plus proche de l'ouverture 12 que la quatrième rangée 42, tandis que, pour les segments de bobine 22 et 24, la quatrième rangée 42 est plus proche de l'ouverture 12 que la troisième rangée 40.

Par exemple, les orifices de la première rangée 36 sont disposés en quinconce avec les orifices de la troisième rangée 40. Les orifices de la deuxième rangée 38 sont disposés en quinconce avec les orifices de la quatrième rangée 42.

Les faces inférieures des bobines 18 et 16 sont agencées de manière analogue, respectivement, sur la face inférieure du substrat 10 et dans la première couche interne.

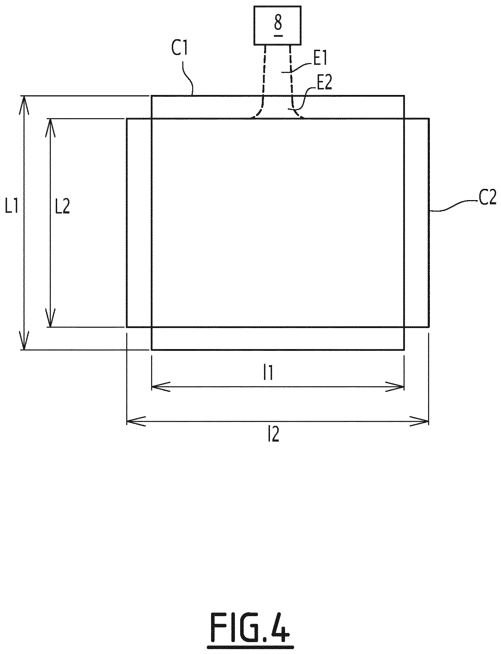

Comme illustré sur la figure 4, le contour en forme de quadrilatère délimité par la première ligne de contour C1 a une longueur L1 supérieure à la longueur L2 du quadrilatère délimité par la deuxième ligne de contour C2 et une largeur ℓ1 inférieure à la largeur ℓ2 du quadrilatère délimité par la deuxième ligne de contour C2.

Cette disposition procure au capteur 6 une meilleure immunité contre les phénomènes de diaphonie, notamment lorsque l'enroulement est soumis à un champ magnétique uniforme. En effet, la superposition des deux bobines avec des surfaces équivalentes mais dont les sens sont opposés permet d'éliminer la contribution de champ uniforme perpendiculaire au capteur. La qualité de la mesure est donc améliorée.

De façon avantageuse, chaque contour C1 et C2 comporte une excroissance, respectivement notée E1 et E2, qui permet de raccorder les bobines au circuit de traitement 8. De préférence, les excroissances E1 et E2 sont superposées.

Selon des exemples, dans chacune des rangées 36, 38, 40 et 42, les orifices sont disposés avec un espacement régulier et, de préférence, sont alignés de façon rectiligne. Toutefois, en variante, les rangées ne sont pas forcément rectilignes, comme on le verra dans l'exemple de la figure 3.

Les bobines 16 et 18 sont entrelacées de telle sorte que, pour chaque segment de bobine 20, 22, 24 et 26, les orifices de la première rangée 36 sont alignés avec les orifices de la quatrième rangée 42 et les orifices de la deuxième rangée 38 sont alignés avec les orifices de la troisième rangée 40.

Selon des modes de réalisation, un motif analogue peut être utilisé pour les zones d'angle 28, 30, 32 et 34. Par exemple, dans la zone d'angle 28, des orifices pour le conducteur de la bobine 18 sont alignés selon deux rangées parallèles situées dans le prolongement des rangées 38 et 40 de la partie de bobine 20. Des orifices pour recevoir le conducteur de la bobine 16 sont alignés selon deux rangées parallèles situées dans le prolongement des rangées 36 et 42 de la partie de bobine 22. Les parties d'angle 30, 32 et 34 sont construites de façon analogue.

Un exemple de conformation des spires de l'enroulement est maintenant décrit. Selon des modes de réalisation, les spires de l'enroulement ont un motif tenant compte de la disposition en quinconce des orifices.

Par exemple, dans chaque segment 20, 22, 24 et 26, la bobine 16 comporte un motif par lequel, dans la face supérieure de la bobine, le conducteur électrique formant la bobine 16 comporte une première partie rectiligne qui s'étend depuis la rangée 40 en direction de la rangée opposée 42 parallèlement au plan du substrat 10 et perpendiculairement à ladite rangée 40.

La première partie rectiligne est prolongée par une deuxième partie rectiligne orientée diagonalement et elle-même prolongée par une troisième partie rectiligne parallèle à la première partie rectiligne. Ces deuxième et troisième parties sont parallèles au plan du substrat 10 et sont coplanaires avec la première partie rectiligne. Cette partie diagonale permet de décaler latéralement le conducteur électrique de manière à ce qu'il se trouve en face de l'orifice correspondant de la rangée 42, au lieu d'être en face d'un des orifices de la rangée 38 prévus pour la deuxième bobine 18. La longueur de la troisième partie est similaire ou égale à celle de la première partie.

Le conducteur se prolonge ensuite vers la face inférieure de la bobine 18 en descendant au travers dudit orifice. Une fois cette face opposée atteinte, le conducteur s'étend depuis la rangée 42 vers la rangée 40 selon une quatrième partie rectiligne similaire et superposée avec la troisième partie rectiligne. La quatrième partie est prolongée par une cinquième partie rectiligne orientée diagonalement, de façon analogue à la deuxième partie sauf qu'elle est inclinée vers côté opposé. De préférence, la cinquième partie a une longueur égale ou sensiblement égale (c'est-à-dire préférentiellement inférieure ou égale à 1 0%) à la longueur de la deuxième partie. Cette cinquième partie est elle-même prolongée vers un orifice correspondant de la rangée 40 par une sixième partie rectiligne parallèle à la quatrième partie rectiligne. Ces cinquième et sixième parties sont parallèles au plan du substrat 10 et sont coplanaires avec la quatrième partie rectiligne.

Le conducteur remonte ensuite vers la face supérieure de la bobine 18 et le même motif est reproduit tel que décrit ci-dessus.

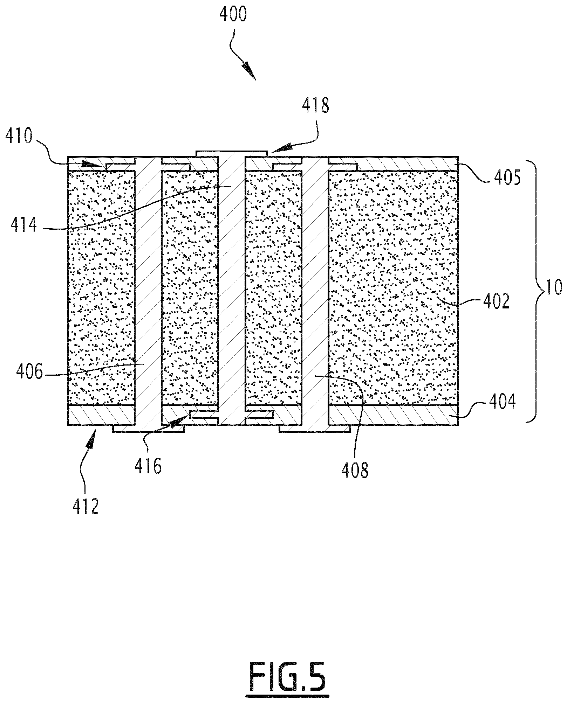

La bobine 16 présente un motif analogue le long des parties rectilignes, mis à part que celui-ci est décalé par rapport à celui de la première bobine, du fait de la disposition en quinconce des orifices le long des rangées 36 et 40 et des rangées 38 et 42. Un tel motif n'est pas complètement visible sur la figure 1, qui ne montre pas la disposition du conducteur dans la partie inférieure de la bobine 16 pour des raisons de clarté. Un motif analogue est en revanche bien visible sur la figure 5 décrite ci-après en référence à la bobine 504. Notamment, le conducteur de la bobine 504 comporte des parties rectilignes similaires à celles du conducteur de la bobine 18. Les parties orientées de façon diagonale sont elles aussi décalées latéralement par rapport à celles du conducteur de la bobine 18 tout en étant disposées à la verticale de celles-ci, par exemple en étant alignées avec celles-ci le long d'une bande de recouvrement qui s'étend parallèlement aux rangées 36, 38, 40 et 42, par exemple située à mi-distance entre les rangées 36 et 42.

En d'autres termes, chaque spire comporte, dans les faces supérieure et inférieure de la bobine, une portion rectiligne orientée diagonalement, les portions rectilignes des bobines étant, dans chaque segment de bobine, alignées le long d'une bande de recouvrement s'étendant parallèlement auxdites rangées 36, 38, 40 et 42.

Cette disposition permet d'obtenir un enroulement compact avec une densité de spires élevée, ce qui améliore les performances du capteur 6.

Des motifs similaires peuvent être utilisés pour les zones d'angle 28, 30, 32 et 34, sauf que les conducteurs de la bobine 16 ne sont pas disposés parallèlement à celui de la bobine 18, mais au contraire sont orientés perpendiculairement à celui-ci dans le plan du substrat 10.

En variante, comme illustré sur la figure 4, les rangées ne sont pas nécessairement rectilignes et peuvent suivre des contours arrondis, par exemple en arc de cercle. Cette disposition non rectiligne peut être utile pour optimiser la disposition des orifices et ainsi gagner de la place sur le substrat 10. Ainsi, l'alignement des orifices peut n'être que partiellement rectiligne, c'est-à-dire qu'au moins une partie des orifices (par exemple jusqu'à 20% ou 40% ou 60% des orifices) de la rangée sont désalignés.

La figure 5 représente un mode de réalisation de l'invention qui peut être combiné avec les modes de réalisation des figures 2 et 3 ou, en alternance, être mis en oeuvre indépendamment de ces modes de réalisation.

Sur cette figure, une portion d'un capteur 400 analogue au capteur 6 est représenté selon une vue en coupe dans un plan géométrique perpendiculaire au plan du substrat 10.

Selon des exemples, le substrat 10 comporte une couche 402 recouverte par une couche inférieure 404 et une couche supérieure 405.

Le capteur 400 comporte un enroulement de Rogowski incluant des bobines jouant un rôle similaire aux bobines 16 et 18 mais qui, en outre, sont imbriquées au sein du substrat 10.

Dans le substrat 10 sont formés une pluralité de premiers vias traversants 406, 408 qui s'étendent chacun, selon une direction perpendiculaire au plan du substrat 10, entre une extrémité supérieure 410 formée à la jonction entre les couches 405 et 402, et une extrémité inférieure 412 formée sur la couche inférieure 404. Les premiers vias 406, 408 sont, par exemple, associés à la deuxième bobine 18 de l'enroulement.

Une pluralité de deuxièmes vias traversants 414, dont seul un est visible sur la figure 4, s'étendent chacun, selon une direction perpendiculaire au plan du substrat 10, entre une extrémité inférieure 416 à la jonction entre les couches 404 et 402, et une extrémité supérieure 418 formée sur la couche 405. Les deuxièmes vias 414 sont, par exemple, associés à la première bobine 16 de l'enroulement.

On comprend que les vias traversants 406, 408 et 414 permettent de former les orifices traversants utilisés pour faire passer les spires des bobines de l'enroulement. Les vias traversants s'étendent dans toute la profondeur de la couche 402.

Ainsi, le substrat 10 peut être plus facilement structuré pour imbriquer les bobines de l'enroulement. Notamment, le procédé de fabrication est simplifié, car seule une étape de métallisation est nécessaire, à la différence de substrats formés par empilement de couches et dans lesquels des vias borgnes débouchent dans une couche intermédiaire de l'empilement, qui nécessitent au moins trois étapes distinctes de métallisation, ce qui renchérit le coût et la complexité du procédé de fabrication.

La figure 5 représente un autre mode de réalisation du capteur 6. Un capteur 500 similaire au capteur 6 précédemment décrit comprend un enroulement 502 incluant une première bobine 504 et une deuxième bobine 506 enroulées sur un substrat pourvu d'une ouverture 508. Les bobines 504 et 506 comportent des segments de bobines 510, 512, 514 et 516 similaires aux parties de bobines 20 à 26 précédemment décrites.

Le capteur 500 diffère notamment du capteur 6 en ce qu'il comporte au moins une zone de raccordement 518 formée dans l'une des parties de bobine pour permettre une connexion électrique de l'enroulement au circuit de traitement 8.

Par exemple, la zone de raccordement 518 comporte des plots de contact auxquels sont raccordés une extrémité terminale de chacune des bobines 504 et 506. Par exemple, la zone de raccordement 518 est formée à mi-largeur de la partie de bobine 514.

Pour permettre le passage des conducteurs électriques des bobines 506 et 508 vers les plots de raccordement au travers du substrat 10, la zone de raccordement 518 comporte des orifices traversants additionnels. Dans l'exemple illustré, ces orifices traversants additionnels sont formés au niveau des rangées d'orifices (analogues aux rangées 38 et 42 précédemment décrites) situées près du bord du substrat 10. Lesdits orifices traversants additionnels sont agencés suivant un motif prédéfini.

De façon avantageuse, un motif 520 analogue (mais n'incluant pas nécessairement lesdits orifices traversants additionnels) est disposé sur le segment de bobine 510 symétriquement par rapport à la zone de raccordement 518.

Cette disposition permet de maintenir une symétrie de l'enroulement. Les bobines peuvent donc être facilement connectées à un circuit de mesure extérieur au capteur 500 sans pour autant devoir introduire un comportement anisotrope capteur. De préférence, des motifs additionnels 522 et 524 de forme analogue sont disposés symétriquement sur les autres segments de bobine 512 et 514.

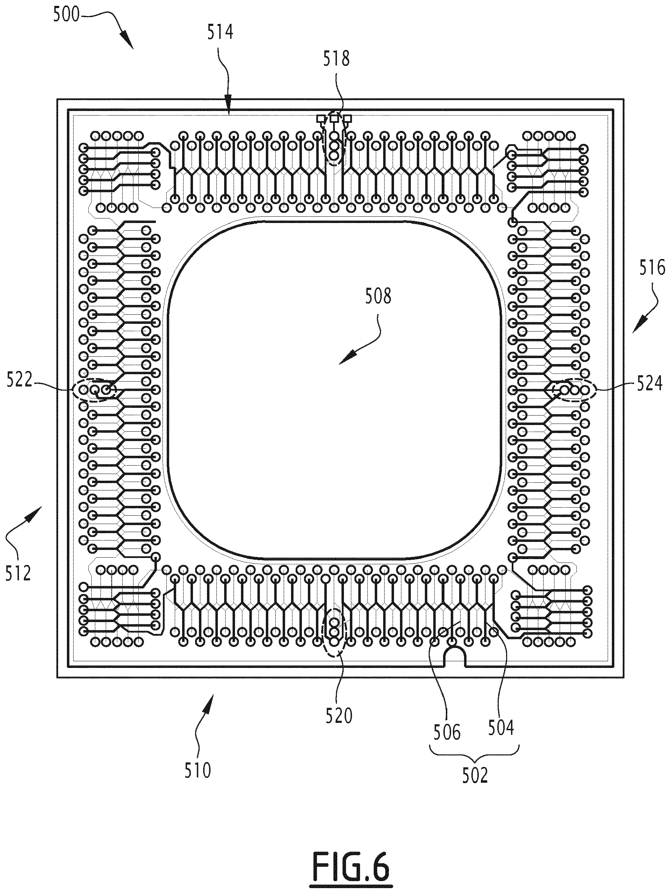

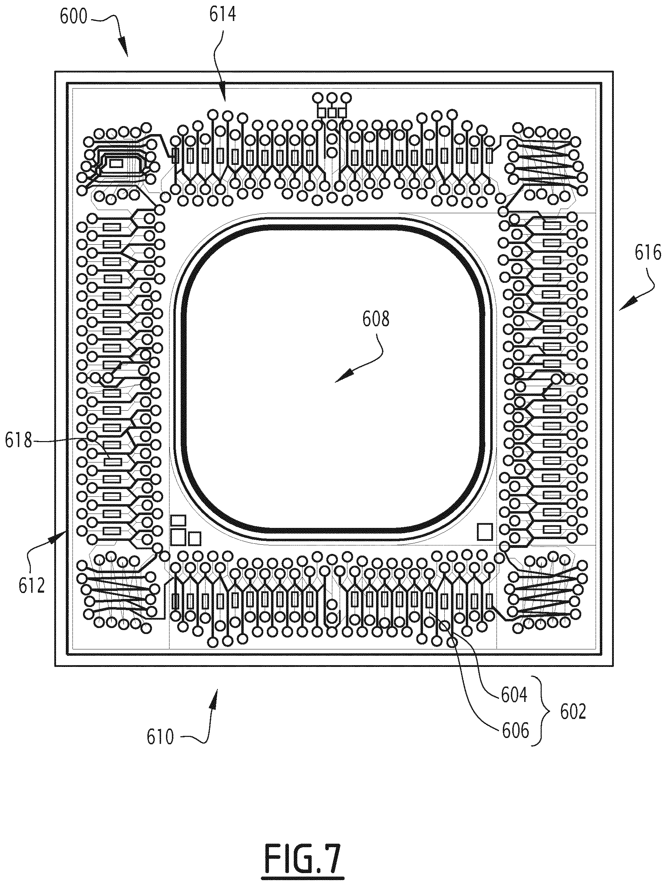

Les figures 6 et 7 représentent d'autres modes de réalisation du capteur 6 ou du capteur 500.

En référence à la figure 6 est décrit un capteur 600 similaire au capteur 6 précédemment décrit et qui comprend un enroulement 602 incluant une première bobine 604 et une deuxième bobine 606 enroulées sur un substrat pourvu d'une ouverture 608. Les bobines 604 et 606 comportent des segments de bobines 610, 612, 614 et 616 similaires aux parties de bobines 20 à 26 précédemment décrites.

Le capteur 600 diffère notamment du capteur 6 en ce que des plots métalliques 618 sont disposés sur le substrat 10, par exemple sur la face supérieure du substrat 10. Les plots 618 forment des plages de soudure pour assurer un assemblage soudé, ayant une bonne résistance mécanique, d'au moins deux capteurs. Les plots 618 ont par exemple une forme rectangulaire.

De préférence, les plots métalliques 618 sont disposés sur des emplacements alignés avec des spires d'une des bobines de l'enroulement, par exemple avec la bobine 606. Dans l'exemple illustré, ces emplacements sont situés dans les segments de bobine 610, 612, 614 et 618 à la verticale des spires de la bobine 606, de préférence au-dessus des spires de la bobine 606.

Comme la face supérieure de la bobine 606 s'étend dans l'une des couches internes dans le substrat 10 sous la face supérieure du substrat 10, les plaques 618 ne sont pas en contact avec la bobine 606. Les plaques 618 sont en outre dimensionnées pour ne pas être en contact avec la bobine 604 et sont ainsi électriquement isolées de l'enroulement 602.

Cette disposition permet de conserver un enroulement compact avec une densité de spires élevée.

De préférence, chaque plaque 618 est placée à mi-distance entre les rangées d'orifices 36 et 42. Pour ce faire, la forme des spires des bobines 604 et 606 peut être modifiée, par exemple en décalant les parties diagonales des conducteurs vers l'une des rangées 36 ou 42, comme visible sur la figure 6. La forme des rangées 36, 38, 40 ou 42 peut alors être localement modifiée de manière à ne plus présenter un alignement rectiligne.

A la place, l'alignement peut être partiellement rectiligne, c'est-à-dire qu'au moins une partie des orifices (par exemple jusqu'à 20% ou 40% ou 60% des orifices) de la rangée sont désalignés.

En référence à la figure 7 est décrit un capteur 700 similaire au capteur 7 et qui comprend un enroulement 702 incluant une première bobine 704 et une deuxième bobine 706 enroulées sur un substrat pourvu d'une ouverture 708. Les bobines 704 et 706 comportent des segments de bobines 710, 712, 714 et 716 similaires aux segments de bobines 610, 612, 614 et 616. Le capteur 700 comporte également des plaques de renfort analogues aux plaques 618 mais qui ne sont pas visibles sur la figure 7.

Le capteur 700 diffère notamment du capteur 600 en ce que la forme de certaines des rangées peut être modifiée, par exemple en suivant une forme recourbée en arc de cercle, comme illustré à titre d'exemple par la ligne pointillée portant la référence 718. Les zones d'angle des bobines 704 et 706 peuvent également être modifiées pour accueillir des plaques de renfort similaires aux plaques 618.

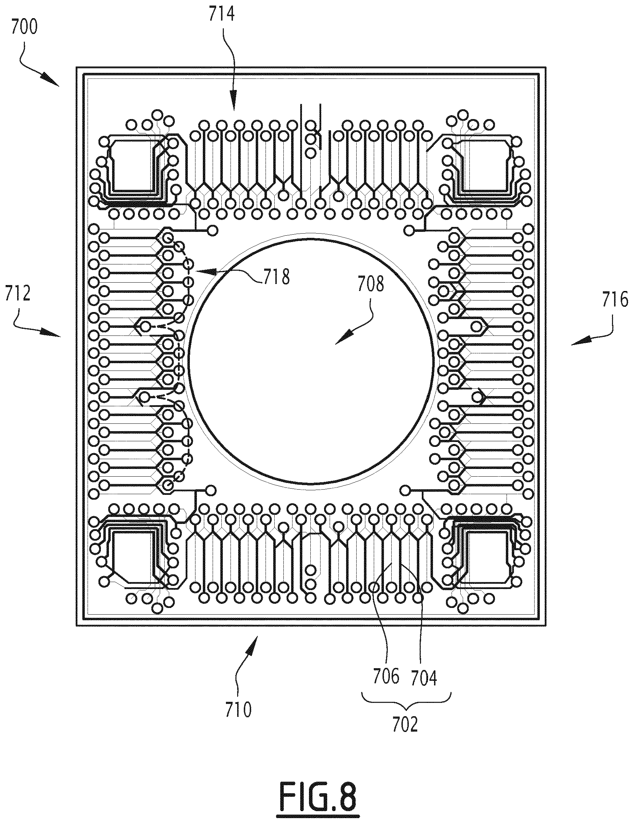

La figure 8 décrit un autre mode de réalisation du capteur 6. Dans ce mode de réalisation, le capteur 800 comporte, sur au moins une partie du substrat, une structure de blindage 802 pour protéger le capteur contre des perturbations électromagnétiques. De préférence, la structure 802 est disposée sur un bord du substrat pour éviter un couplage électromagnétique de l'enroulement avec l'alimentation électrique du système de mesure 2.

Par exemple, la structure 802 comporte une piste 804 électriquement conductrice raccordée à une masse électrique, par exemple à une masse électrique du système 2, cette piste 804 étant déposée sur une face du substrat.

Avantageusement, des trous 806 sont percés dans le substrat le long de la piste 804.

L'invention est définie par les revendications annexées.

## Revendications

1. Capteur de courant (6) comportant :
- un substrat isolant (10) pourvu d'une ouverture centrale (12) ;
- un enroulement de Rogowski (14) entourant l'ouverture centrale et incluant une première bobine (16) et une deuxième bobine (18) superposées et connectées électriquement en série, la première bobine et la deuxième bobine étant enroulées autour du substrat selon, respectivement, une première ligne de contour (C1) et une deuxième ligne de contour (C2), chaque ligne de contour délimitant, dans le plan du substrat, un contour en forme de quadrilatère centré autour de l'ouverture centrale ;
**caractérisé en ce que** le contour en forme de quadrilatère délimité par la première ligne de contour (C1) a une longueur (L1) supérieure à la longueur (L2) du quadrilatère délimité par la deuxième ligne de contour (C2) et une largeur (f1) inférieure à la largeur (ℓ2) du quadrilatère délimité par la deuxième ligne de contour (C2).

2. Capteur de courant selon la revendication 1, dans lequel chacune des bobines (16, 18) est partagée en une pluralité de segments de bobines (20, 22, 24, 26) agencés autour de l'ouverture centrale en étant superposés et sensiblement alignés le long des lignes de contour (C1, C2), chacun desdits segments (20, 22, 24, 26) comportant une pluralité de spires au moins en partie reçues dans des orifices traversants percés dans le substrat, les orifices traversant étant alignés le long de rangées (36, 38, 40, 42).

3. Capteur de courant selon la revendication 2, dans lequel, pour chaque partie de bobine, les orifices associés aux première et deuxième bobines sont disposés en quinconce.

4. Capteur de courant selon la revendication 3, dans lequel chaque spire comporte, dans les faces supérieure et inférieure de la bobine, une portion rectiligne orientée diagonalement, les portions rectilignes des bobines étant, dans chaque segment de bobine, alignées le long d'une bande de recouvrement s'étendant parallèlement auxdites rangées (36, 38, 40, 42).

5. Capteur de courant selon l'une quelconque des revendications 2 à 4, dans lequel le capteur de courant (500) comporte une zone de raccordement (518) formée dans l'un des segments de bobine, ladite zone de raccordement comportant des orifices traversants disposés selon un motif prédéfini, le capteur de courant (500) comportant en outre des orifices traversants supplémentaires (520, 522, 524) disposés suivant le même motif et disposés dans un autre des segments de bobine symétriquement par rapport à la zone de raccordement

6. Capteur de courant selon l'une quelconque des revendications 2 à 5, dans lequel les orifices traversants sont des vias traversants (404, 406, 414) s'étendant dans toute la profondeur d'une couche centrale (402) du substrat.

7. Capteur de courant selon l'une quelconque des revendications 2 à 5, dans lequel lesdites bobines (16, 18) comportent également des zones d'angle (28, 30, 32, 34) disposées chacune dans l'angle entre deux segments de bobine adjacents et dans lesquels passent les conducteurs électriques desdites bobines pour raccorder les segments de bobine.

8. Capteur de courant (600, 700) selon l'une quelconque des revendications précédentes, dans lequel des plots métalliques de soudure (618) sont disposés sur le substrat sur des emplacements alignés avec des spires d'une des bobines de l'enroulement.

9. Capteur de courant (800) selon l'une quelconque des revendications précédentes, dans lequel une structure de blindage (802) est formée sur au moins une partie du substrat pour protéger le capteur contre des perturbations électromagnétiques, cette structure comportant une piste (804) électriquement conductrice raccordée à une masse électrique.

10. Système de mesure (2) **caractérisé en ce qu'**il comporte un capteur de courant (6 ; 6') selon l'une quelconque des revendications précédentes et un circuit électronique de traitement (8) configuré pour traiter le signal mesuré par le capteur de courant (6 ; 6')

## Patentansprüche

1. Stromsensor (6), umfassend:
- ein isolierendes Substrat (10), das mit einer mittleren Öffnung (12) versehen ist;
- eine Rogowski-Wicklung (14), die die mittlere Öffnung umgibt und eine erste Spule (16) und eine zweite Spule (18) beinhaltet, die übereinander angeordnet und elektrisch in Reihe geschaltet sind, wobei die erste Spule und die zweite Spule entlang einer ersten Konturlinie (C1) bzw. einer zweiten Konturlinie (C2) um das Substrat gewickelt sind, wobei jede Konturlinie in der Ebene des Substrats eine Kontur in Form eines Vierecks begrenzt, das um die mittlere Öffnung zentriert ist;
**dadurch gekennzeichnet, dass** die viereckige Kontur, die durch die erste Konturlinie (C1) begrenzt ist, eine Länge (L1) aufweist, die größer ist als die Länge (L2) des Vierecks, das durch die zweite Konturlinie (C2) begrenzt ist, und eine Breite (ℓ1), die kleiner ist als die Breite (Q2) des Vierecks, das durch die zweite Konturlinie (C2) begrenzt ist.

2. Stromsensor nach Anspruch 1, wobei jede der Spulen (16, 18) in eine Vielzahl von Spulensegmenten (20, 22, 24, 26) unterteilt ist, die um die mittlere Öffnung angeordnet sind, indem sie übereinander liegen und im Wesentlichen entlang von Konturlinien (C1, C2) ausgerichtet sind, wobei jedes der Segmente (20, 22, 24, 26) eine Vielzahl von Windungen aufweist, die zumindest teilweise in Durchgangslöchern aufgenommen sind, die in das Substrat gebohrt sind, wobei die Durchgangslöcher entlang von Reihen (36, 38, 40, 42) ausgerichtet sind.

3. Stromsensor nach Anspruch 2, wobei die Öffnungen, die mit der ersten und der zweiten Spule assoziiert sind, für jeden Spulenteil versetzt angeordnet sind.

4. Stromsensor nach Anspruch 3, wobei jede Windung in der Ober- und der Unterseite der Spule einen diagonal ausgerichteten geraden Abschnitt aufweist, wobei die geraden Abschnitte der Spulen in jedem Spulensegment entlang eines sich parallel zu den genannten Reihen (36, 38, 40, 42) erstreckenden Abdeckstreifens ausgerichtet sind.

5. Stromsensor nach einem der Ansprüche 2 bis 4, wobei der Stromsensor (500) einen Anschlussbereich (518) umfasst, der in einem der Spulensegmente gebildet ist, wobei der Anschlussbereich Durchgangslöcher umfasst, die in einem vorbestimmten Muster angeordnet sind, der Stromsensor (500) ferner umfassend zusätzliche Durchgangsöffnungen (520, 522, 524), die in demselben Muster angeordnet sind und in einem anderen der Spulensegmente symmetrisch in Bezug auf den Anschlussbereich angeordnet sind

6. Stromsensor nach einem der Ansprüche 2 bis 5, wobei die Durchgangslöcher Durchkontaktierungen (404, 406, 414) sind, die sich durch die gesamte Tiefe einer mittleren Schicht (402) des Substrats erstrecken.

7. Stromsensor nach einem der Ansprüche 2 bis 5, wobei die Spulen (16, 18) auch Winkelbereiche (28, 30, 32, 34) umfassen, die jeweils in dem Winkel zwischen zwei benachbarten Spulensegmenten angeordnet sind und durch die die elektrischen Leiter der Spulen verlaufen, um die Spulensegmente zu verbinden.

8. Stromsensor (600, 700) nach einem der vorherigen Ansprüche, wobei metallische Lötkontakte (618) auf dem Substrat an Stellen angeordnet sind, die mit den Windungen einer der Spulen der Wicklung ausgerichtet sind.

9. Stromsensor (800) nach einem der vorherigen Ansprüche, wobei eine Abschirmungsstruktur (802) auf mindestens einem Teil des Substrats gebildet ist, um den Sensor gegen elektromagnetische Störungen abzuschirmen, wobei diese Struktur eine elektrisch leitende Spur (804) aufweist, die mit einer elektrischen Masse verbunden ist.

10. Messsystem (2), **dadurch gekennzeichnet, dass** es einen Stromsensor (6; 6') nach einem der vorherigen Ansprüche und eine elektronische Verarbeitungsschaltung (8) umfasst, die konfiguriert ist, um das von dem Stromsensor (6; 6') gemessene Signal zu verarbeiten.

## Claims

1. Current sensor (6) comprising:
- an insulating substrate (10) with a central opening (12);
- a Rogowski winding (14) surrounding the central aperture and including a first coil (16) and a second coil (18) superimposed and electrically connected in series, the first coil and the second coil being wound round the substrate along, respectively, a first contour line (C1) and a second contour line (C2), each contour line delimiting, in the plane of the substrate, a quadrilateral-shaped contour centred around the central opening;
**characterised in that** the quadrilateral contour delimited by the first contour line (C1) has a length (L1) greater than the length (L2) of the quadrilateral delimited by the second contour line (C2) and a width (ℓ1) less than the width (ℓ2) of the quadrilateral delimited by the second contour line (C2).

2. Current sensor as claimed in claim 1, wherein each of the coils (16, 18) is divided into a plurality of coil segments (20, 22, 24, 26) arranged around the central aperture in superimposed relationship and substantially aligned along the contour lines (C1, C2), each of said segments (20, 22, 24, 26) comprising a plurality of turns at least partly received in through-holes drilled in the substrate, the through-holes being aligned along rows (36, 38, 40, 42).

3. Current sensor according to claim 2, in which, for each coil part, the holes associated with the first and second coils are arranged in a staggered pattern.

4. Current sensor according to claim 3, wherein each turn comprises, in the upper and lower faces of the coil, a diagonally oriented rectilinear portion, the rectilinear portions of the coils being, in each coil segment, aligned along a covering strip extending parallel to said rows (36, 38, 40, 42).

5. Current sensor according to any one of claims 2 to 4, wherein the current sensor (500) comprises a connection area (518) formed in one of the coil segments, said connection area comprising through holes arranged in a predefined pattern, the current sensor (500) further comprising additional through holes (520, 522, 524) arranged in the same pattern and arranged in another of the coil segments symmetrically with respect to the connection area.

6. Current sensor according to any one of claims 2 to 5, wherein the through-holes are through-vias (404, 406, 414) extending throughout the depth of a central layer (402) of the substrate.

7. Current sensor according to any one of claims 2 to 5, wherein said coils (16, 18) also include corner regions (28, 30, 32, 34) each arranged in the corner between two adjacent coil segments and through which the electrical conductors of said coils pass to connect the coil segments.

8. Current sensor (600, 700) according to any one of the preceding claims, wherein metal solder pads (618) are arranged on the substrate at locations aligned with turns of one of the coils of the winding.

9. Current sensor (800) according to any one of the preceding claims, in which a shielding structure (802) is formed on at least part of the substrate to protect the sensor against electromagnetic interference, this structure comprising an electrically conductive track (804) connected to an electrical earth.

10. Measurement system (2), **characterised in that** it comprises a current sensor (6; 6') according to any one of the preceding claims and an electronic processing circuit (8) configured to process the signal measured by the current sensor (6; 6')
